# EUROPÄISCHE PATENTSCHRIFT

(11) **EP 2 801 799 B1**
(45) Veröffentlichungstag und Bekanntmachung des Hinweises auf die Patenterteilung: **16.03.2016**
(21) Anmeldenummer: 13167026.7
(22) Anmeldetag: 08.05.2013
(51) Int. Cl.: G01F 23/296

(54) **Vibrations-Grenzstandschalter**
Vibration level switch
Commutateur de niveau à vibration

(43) Veröffentlichungstag der Anmeldung: 12.11.2014
(73) Patentinhaber: VEGA Grieshaber KG, 77709 Wolfach (DE)
(72) Erfinder: Gruhler, Holger, 78609 Tuningen (DE)
(74) Vertreter: Westphal, Mussgnug & Partner Patentanwälte mbB

(56) Entgegenhaltungen:
- EP-A1- 2 209 110
- DE-A1-102006 016 355
- DE-C1- 3 931 453
- DE-C1- 19 840 211
- JP-A- S56 149 900

## Beschreibung

Die vorliegende Erfindung betrifft einen Vibrations-Grenzstandschalter gemäß dem Oberbegriff des Patentanspruchs 1 sowie ein Verfahren zum Betreiben eines solchen Vibrations-Grenzstandschalters gemäß Patentanspruch 15.

Aus dem Stand der Technik sind verschiedentlich Vibrations-Grenzstandschalter mit einer in Schwingung versetzbaren Membran und einem Antrieb zum Versetzen der Membran in Schwingung und/oder zum Abgreifen einer Schwingung der Membran bekannt, wobei als Antrieb entweder piezoelektrische Elemente oder ein elektromagnetischer Antrieb zum Einsatz kommen. Derartige Vibrations-Grenzstandschalter werden insbesondere zur Detektion von Füllständen bzw. Grenzständen in Behältern für fließfähige und fluidisierbare Medien, insbesondere bei Flüssigkeiten oder Schüttgütern eingesetzt. Die Vibrations-Grenzstandschalter sind je nach Füllstand in dem Behälter mit dem Medium in Kontakt oder nicht, sodass eine Schwingfrequenz der Membran bzw. an der Membran angeordneter Schwingelemente durch den Kontakt mit dem Medium beeinflusst wird.

DE 39 31 453 C1 offenbart einen solchen Vibrations-Grenzstandschalter mit einem piezoelektrischen Antrieb. DE 10 2006 016 355 A1 und EP 2 209 110 A1 offenbaren Vibrationssensoren mit elektromagnetischem Antrieb.

Bei den aus dem Stand der Technik bekannten Vibrations-Grenzstandsschaltern wird es als nachteilig empfunden, dass diese abhängig vom verwendeten Antrieb über einen begrenzten, insbesondere begrenzten thermischen und mechanischen Einsatzbereich verfügen.

Es ist die Aufgabe der vorliegenden Erfindung einen Vibrations-Grenzstandschalter zur Verfügung zu stellen, der über einen breiten Einsatzbereich hinweg verwendbar ist.

Diese Aufgabe wird durch einen Vibrations-Grenzstandschalter mit den Merkmalen des Patentanspruchs 1 gelöst. Ein vorteilhaftes Verfahren zum Betreiben eines solchen Vibrations-Grenzstandschalters ist in Patentanspruch 15 widergegeben.

Ein erfindungsgemäßer Vibrations-Grenzstandschalter weist eine in Schwingung versetzbare Membran und eine Antriebseinheit zum Versetzen der Membran in Schwingung und/oder zum Abgreifen einer Schwingung der Membran auf, wobei die Antriebseinheit wenigstens einen elektromagnetischen Antrieb und einen piezoelektrischen Antrieb umfasst.

Durch die Zusammenfassung eines elektromagnetischen Antriebs und eines piezoelektrischen Antriebs in einer gemeinsamen Antriebseinheit wird ein Vibrations-Grenzstandschalter geschaffen, der über einen breiten Temperatur- und Druckbereich hinweg einsetzbar ist.

Da ein piezoelektrischer Antrieb eine sehr gute Kopplung zwischen dem Antrieb und der in Schwingung versetzbaren Membran aufweist, ist dieser gut für hochviskose Medien geeignet, ist aber auf Grund der kleinen erzeugten Amplitude stark von einem auf die Membran bzw. auf ein an der Membran angeordnetes Schwingelement wirkenden Druck abhängig, wodurch beispielsweise bei einer Entlastung eines als Antrieb verwendeten Piezostapels oder einer z.B. thermischen Änderung einer auf den Piezostapel wirkenden Vorspannung ein Versagen des Antriebs auftreten kann. Darüber hinaus ist ein piezoelektrischer Antrieb stark temperaturabhängig, da der piezoelektrische Effekt bei höheren Temperaturen deutlich abnimmt.

Andererseits weisen induktive Antriebe eine schwache Ankopplung des Antriebes an die Membran auf, sodass diese für hochviskose Medien nicht geeignet sind. Da mit einem induktiven Antrieb jedoch größere Amplituden erzeugbar sind, ist dieser Antrieb im Vergleich zu piezoelektrischen Antrieben deutlich weniger durch von außen wirkende Drücke beeinflussbar, sodass - insbesondere da keine mechanische Vorspannung des Antriebs notwendig ist - ein Einsatz auch bei höheren Drücken möglich ist.

Die positiven Eigenschaften der beiden vorgenannten Antriebsvarianten lassen sich durch eine geschickte Kombination eines elektromagnetischen Antriebs und eines piezoelektrischen Antriebs miteinander derart kombinieren, dass insbesondere bei bestimmten Einsatzszenarien die Nachteile des jeweils anderen Antriebs kompensiert werden und so ein universell einsetzbarer Vibrations-Grenzstandschalter zur Verfügung gestellt werden kann.

Insbesondere bei Messungen im Bereich thixotroper Medien, die eine erhöhte Fließfähigkeit unter Druck aufweisen, kann beispielsweise im Bereich des normalen Drucks, bei dem das zu messende Medium eine hohe Viskosität aufweist, der Piezoantrieb zu einer Grenzstandsmessung verwendet werden, wohingegen der induktive Antrieb in dieser Situation nicht funktionieren würde. Bei einer Drucksteigerung auf einen Prozessdruck, bei dem das zu messende Medium eine verringerte Viskosität aufweist, kann dann der bei höherem Druck einsetzbare induktive Antrieb zum Einsatz kommen, wohingegen der piezoelektrische Antrieb auf Grund des einwirkenden Druckes und einer Entlastung des als Antrieb verwendeten Piezostapels nicht mehr funktioniert.

Eine ähnliche Situation kann bei Messungen an Medien eintreten, deren Viskosität sich unter thermischem Einfluss ändert.

Bei Medien, die beispielsweise bei Raumtemperatur eine hohe Viskosität aufweisen, kann in dieser Situation der Piezoantrieb zum Einsatz kommen, wohingegen der induktive Antrieb auf Grund der zu schwachen Kopplung zwischen Antrieb und Membran nicht geeignet ist. Bei einer erhöhten Temperatur, bei der das Medium eine geringere Viskosität aufweist, ist der Piezoantrieb auf Grund der höheren Temperatur nicht mehr optimal geeignet, es kann aber der induktive Antrieb auf Grund der gesunkenen Viskosität des zu messenden Mediums eingesetzt werden.

In einer besonders günstigen Ausgestaltungsform eines Vibrations-Grenzstandschalters ist an der Membran eine Schwingeinheit, die beispielsweise als Schwinggabel ausgebildet sein kann, angeordnet. Durch das Vorsehen einer derartigen Schwingeinheit wird eine Vibration der Membran besser auf ein umgebendes Medium übertragen, sodass auch eine bessere Detektion einer Dämpfung dieser Schwingung ermöglicht wird.

In einer günstigen Ausgestaltungsform sind der elektromagnetische Antrieb und der piezoelektrische Antrieb derart angeordnet, dass wahlweise der elektromagnetische Antrieb und/oder der piezoelektrische Antrieb zum in Schwingung versetzen der Membran nutzbar ist.

Es wird auf diese Weise erreicht, dass entweder der elektromagnetische Antrieb oder der piezoelektrische Antrieb oder wahlweise beide Antriebe zum in Schwingung versetzen der Membran verwendbar sind. Es kann auf diese Weise jeweils der optimale Antrieb bzw. die optimale Kombination aus Antrieben für die aktuell herrschenden Prozessparameter ausgewählt werden.

Eine besonders kompakte Bauform wird erreicht, wenn der elektromagnetische Antrieb und der piezoelektrische Antrieb mechanisch in Reihe geschaltet sind.

Es ist dabei besonders günstig, wenn der piezoelektrische Antrieb zwischen der Membran und dem elektromagnetische Antrieb angeordnet ist. Auf diese Weise kann der piezoelektrische Antrieb möglichst direkt und unmittelbar an die Membran des Vibrations-Grenzstandschalters angekoppelt werden.

Bei Verwendung eines vorgespannten Piezostapels als piezoelektrischer Antrieb sowie für die Verwendung eines elektromagnetischen Antriebs ist es vorteilhaft, wenn an der Membran ein Zubolzen angeordnet ist. Ein solcher Zugbolzen kann einerseits dazu verwendet werden, dass ein als Antrieb verwendeter Stapel von Piezoelementen gegen die Membran gespannt wird und andererseits eine Schwingung des elektromagnetischen Antriebes über den Zugbolzen auf die Membran eingekoppelt wird. Der elektromagnetische Antrieb wirkt dabei bevorzugt rückseitig auf den Zugbolzen und ist bevorzugt mit diesem fest verbunden, beispielsweise verschraubt oder verschweißt.

Ein besonders günstiger mechanischer Aufbau kann erreicht werden, wenn der elektromagnetische Antrieb derart mit dem Zugbolzen verschraubt ist, dass er den piezoelektrischen Antrieb gegen die Membran spannt. Auf diese Weise kann auf eine ansonsten notwendige Spannvorrichtung beispielsweise eine Spannschraube für den piezoelektrischen Antrieb verzichtet werden.

Der elektromagnetische Antrieb kann beispielsweise auch dazu verwendet werden, eine Vorspannung des piezoelektrischen Antriebs an aktuelle Prozessparameter anzupassen. Es kann dafür statisch oder dynamisch eine Kraftwirkung auf den Piezoantrieb erzeugt werden.

Alternativ ist es möglich, dass der piezoelektrische Antrieb nicht mittels vorgespannter Stapel, sondern als mit der Membran verklebtes Piezoelement ausgeführt ist.

Der Zugbolzen kann außerdem wenigstens abschnittsweise als Spulenkern des elektromagnetischen Antriebs ausgebildet und angeordnet sein. Auf diese Weise wird durch eine Verwendung des Zubolzens als Spulenkern eine unmittelbare Übertragung einer in dem elektromagnetischen Antrieb erzeugten Schwingung auf den Zugbolzen erreicht.

Der Zugbolzen kann dazu bevorzugt mit einer Spulenaufnahme oder einer Magnetaufnahme des elektromagnetischen Antriebs fest verbunden sein, wobei die Spulen- oder Magnetaufnahme bevorzugt als Spannschraube für den piezoelektrischen Antrieb ausgebildet ist.

Der piezoelektrische Antrieb kann dafür bevorzugt als eine Mehrzahl gestapelt angeordneter ringförmig ausgebildete Piezoelemente ausgebildet sein, die zur Vergrößerung einer erzeugten Amplitude geeignet angeordnet sind.

Alternativ kann der piezoelektrische Antrieb ein ringförmiges Piezoelement aufweisen, das mit der Membran verklebt ist, sodass keine Vorspannung des piezoelektrischen Antriebs notwendig ist.

Ein erfindungsgemäßes Verfahren zum Betreiben eines oben beschriebenen Vibrations-Grenzstandschalters weist nachfolgende Schritte auf:
- Versetzen der Membran in Schwingung
- Detektieren einer resultierenden Schwingung, wobei wahlweise ein elektromagnetischer Antrieb und/oder ein piezoelektrischer Antrieb zum Versetzen der Membran in Schwingung und/oder Detektieren der resultierenden Schwingung verwendet wird.

Durch ein wahlweises Verwenden entweder des elektromagnetischen Antriebs oder des piezoelektrischen Antriebs kann ein erhöhter thermischer und mechanischer Einsatzbereich eines Vibrations-Grenzstandschalters erreicht werden.

Eine Auswahl des zu verwendenden Antriebs erfolgt vorzugsweise abhängig von einer Viskosität und/oder einer Temperatur eines Prozessmediums, wobei vorzugsweise bei niedriger Temperaturen und/oder Drücken der piezoelektrische Antrieb und bei hohen Drücken und/oder Temperaturen der induktive Antrieb ausgewählt wird. In einer bevorzugten Ausgestaltung des Verfahrens wird der eine Antrieb zum Versetzen der Membran in Schwingung und der andere Antrieb zum detektieren der resultierten Schwingung verwendet. Es kann auf diese Weise eine Redundanz der Antriebe geschaffen werden.

Die vorliegende Erfindung wird nachfolgend anhand von Ausführungsbeispielen und bezogen auf die beigefügten Figuren eingehend erläutert. Es zeigen:
- Fig. 1: eine Prinzipskizze eines ersten Ausführungsbeispiels eines erfindungsgemäßen Vibrations-Grenzstandschalters und
- Fig. 2: ein zweites Ausführungsbeispiel eines erfindungsgemäßen Vibrations-Grenzstandschalters.

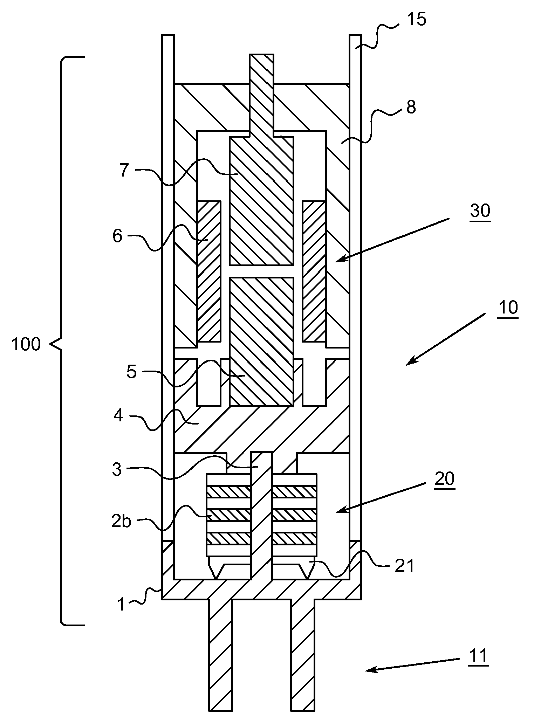

Figur 1 zeigt eine schematische Darstellung eines ersten Ausführungsbeispiels eines Vibrations-Grenzstandschalters 10 gemäß der vorliegenden Anmeldung.

Der Vibrations-Grenzstandschalter 10 weist ein im Wesentlichen rohrförmig ausgebildetes Gehäuse 15 auf. In dem Gehäuse 15 ist eine Antriebseinheit 100 gelagert, die im vorliegenden Ausführungsbeispiel aus einem vorderseitig, d. h. in Richtung einer Membran 1 angeordneten piezoelektrischen Antrieb 20 und einem rückseitig angeordneten elektromagnetischen Antrieb 30 gebildet ist. Vorderseitig ist an dem Gehäuse 15 eine durch die Antriebe 20, 30 in Schwingung versetzbare Membran 1 angeordnet, die eine als Schwinggabel ausgebildete Schwingeinheit 11 trägt. Gehäuse innenseitig ist an der Membran 1 ein Zugbolzen 3 angeordnet, der mit den Antrieben 20, 30 derart in Verbindung steht, dass diese die Membran 1 in Schwingung versetzen können. Der Zugbolzen 3 erstreckt sich dazu zentrisch in Richtung einer Längsachse des Gehäuses 15.

Der piezoelektrische Antrieb 20 ist in dem in der Figur 1 dargestellten ersten Ausführungsbeispiel als ein Stapel von mehreren Piezoelementen 2b ausgebildet, die über eine zwischen dem Piezostapel und der Membran 1 angeordneten Druckring 21 mit der Membran 1 in Wirkverbindung stehen. Die Piezoelemente 2b sind ringförmig ausgebildet und derart gestapelt, dass sie bei geeigneter Anregung eine Ausdehnung bzw. Kontraktion in Längsrichtung des Zugbolzens 3 ausführen. Der Stapel aus Piezoelementen 2b ist rückseitig mittels einer Spannmutter 4, die auf dem Zugbolzen 3 sitzt in Richtung der Membran 1 vorgespannt.

Im vorliegenden Ausführungsbeispiel ist die Spannmutter 4 als Magnetaufnahme des elektromagnetischen Antriebs 30 ausgebildet, in der ein Permanentmagnet 5 fest aufgenommen ist. Durch die Verschraubung der Magnetaufnahme 4 mit dem Spannbolzen 3 wird außerdem eine Wirkverbindung zwischen dem elektromagnetischen Antrieb 30 und der Membran 1 hergestellt. Der elektromagnetische Antrieb 30 weist außerdem eine korrespondierend zu der Magnetaufnahme ausgebildete Spulenaufnahme 8 auf, die rückseitig in dem Gehäuse 15 feststehend angeordnet ist. In der Spulenaufnahme 8 ist einerseits ein Spulenkern 7 gelagert, der sich von der Rückseite her zentral in Richtung des Permanentmagneten 5 erstreckt und andererseits eine Spule 6 gelagert, die den Spulenkern 7 und den Permanentmagneten 5 umgibt. Der Spulenkern 7 und der Permanentmagnet 5 sind derart ausgebildet und angeordnet, dass zwischen diesen Komponenten innerhalb der Spule ein Luftspalt gebildet ist, in dem ein durch die Spule 6 induziertes Magnetfeld wirkt. Ein weiterer Luftspalt ist zwischen der Magnetaufnahme 4 sowie der dazu korrespondierend ausgebildeten Spulenaufnahme 8 gebildet, sodass ein in der Spule 6 induziertes Magnetfeld insgesamt auf die Magnetaufnahme 4 wirkt, wodurch eine Kraftwirkung auf den Zugbolzen 3 erreicht wird.

Insgesamt kann der elektromagnetische Antrieb 3 auch in umgekehrter Orientierung in dem Gehäuse 15 sitzen. In diesem Fall ist die Spulenaufnahme 8 mit dem Zugbolzen 3 verbunden und die Magnetaufnahme 4 feststehend in dem Gehäuse 15 angeordnet.

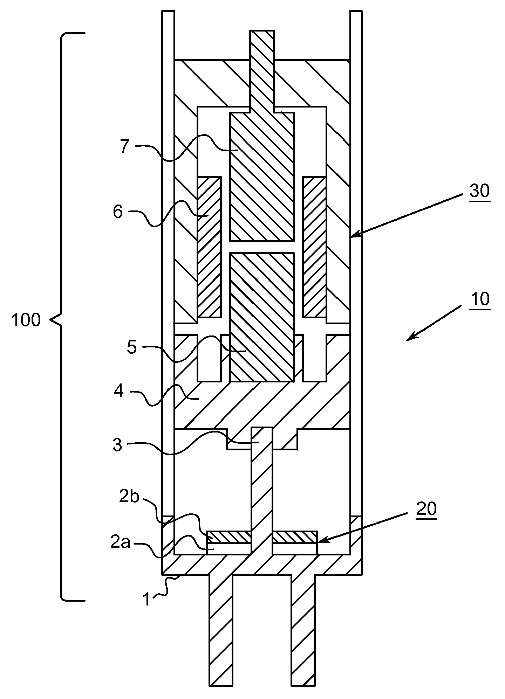

Figur 2 zeigt ein weiteres Ausführungsbeispiel eines Vibrations-Grenzstandschalters 10.

Im Unterschied zu dem Vibrations-Grenzstandschalter 10 aus Figur 1 ist der piezoelektrische Antrieb 20 im vorliegenden Ausführungsbeispiel mit einem einzelnen ringförmig ausgebildeten Piezoelement 2b gebildet, das über eine Anpassungskeramik 2a mit der Membran 1 verklebt ist. Die Anpassungskeramik 2a dient im vorliegenden Ausführungsbeispiel zur Übertragung der Schwingung des Piezoelements 2b sowie zur Anpassung der thermischen Ausdehnungskoeffizienten der Membran 1 und des Piezoelements 2b. Der elektromagnetische Antrieb 30 ist, wie in Bezug auf Figur 1 bereits beschrieben, rückseitig in dem Gehäuse 15 angeordnet und über die Magnetaufnahme 4 mit dem Zugbolzen 3 derart gekoppelt, dass eine durch ein in der Spule 6 induziertes Magnetfeld erzeugte Schwingung auf die Membran 1 übertragen wird.

Die vorstehend beschriebenen Vibrations-Grenzstandschalter 10 ermöglichen durch den Aufbau ihrer Antriebseinheit 100 mit zwei nach unterschiedlichen Prinzipien arbeitenden Antrieben 20, 30 einen Einsatz bei vielfältigen Betriebs- und Umgebungsbedingungen.

Es kann dabei beispielsweise wahlweise lediglich einer der Antriebe 20, 30 zum Versetzen der Membran 1 in Schwingung sowie zum Detektieren einer resultierenden Schwingung der Membran 1 verwendet werden. Eine Auswahl des günstigerweise zu verwendenden Antriebs 20, 30 kann dabei anhand der herrschenden Prozessparameter, beispielsweise einer Prozesstemperatur eines Prozessdrucks und/oder einer Viskosität eines zu messenden Prozessmediums erfolgen, wobei die spezifischen Eigenschaften der eingesetzten Antriebe 20, 30 berücksichtigt werden.

Der piezoelektrische Antrieb 20 kann dabei bevorzugt bei Medien hoher Viskosität, bei Normaldruck sowie bei Temperaturen unter ca. 120-150_C° eingesetzt werden. Bei Medien geringer Viskosität, bei hohen Drücken sowie Temperaturen über ca. 120-150_°C wird dann bevorzugt der elektromagnetische Antrieb 30 verwendet.

Ein mögliches Einsatzszenario für einen Vibrations-Grenzstandschalter 10 mit einem Hybridantrieb gemäß der vorliegenden Erfindung liegt beispielsweise bei der Grenzstandsüberwachung von Schweröl, welches um es pumpfähig zu machen, auf eine Temperatur von 60°C erwärmt und für eine Verbrennung auf über 150°C aufgeheizt werden muss. Ein Betrieb des Vibrations-Grenzstandschalters 10 kann damit für das zähflüssige Schweröl bis zu einer Temperatur von ca. 120-150_°C über den piezoelektrischen Antrieb 20 angetrieben werden. Eine Detektion einer resultierenden Schwingung der Membran 1 kann ebenfalls über den piezoelektrischen Antrieb 20 erfolgen. Durch die gute mechanische Kopplung des piezoelektrischen Antriebs 20 und der Membran 1 kann auch in hochviskosen Medien eine ausreichend starke Schwingung der Membran 1 induziert werden, um eine Grenzstandsdetektion zu ermöglichen. Sobald die Grenztemperatur für den Einsatz des piezoelektrischen Antriebs 20 überschritten ist, nimmt der piezoelektrische Effekt in den Piezoelementen 2b derart ab, dass keine ausreichende Schwingung der Membran 1 mehr erzeugt werden kann. Da aber auf Grund der erhöhten Temperatur das Schweröl eine entsprechend geringere Viskosität aufweist, ist nun ein Einsatz des elektromagnetischen Antriebs 30 zum in Schwingung versetzen der Membran 1 sowie zum Detektieren einer resultierenden Schwingung möglich, da in dieser Situation auch die schwächere mechanische Ankopplung des elektromagnetischen Antriebs 30 an die Membran 1 zur Erzeugung einen hinreichend großen Schwingung der Membran 1 ausreicht.

Ein weiteres Anwendungsbeispiel für einen Vibrations-Grenzstandschalter 10 gemäß der vorliegenden Anmeldung liegt bei einer Grenzstandsdetektion thixotroper Medien, die unter Druck eine erhöhte Fließfähigkeit, d. h. eine geringere Viskosität aufweisen.

Bei Normaldruck, bei dem diese Medien eine erhöhte Viskosität aufweisen, wird bevorzugt der piezoelektrische Antrieb 20 zur Anregung einer Schwingung der Membran 1 sowie der Schwinggabel 11 verwendet. Durch die starke mechanische Kopplung zwischen dem piezoelektrischen Antrieb 20 und der Membran 1 kann hier eine ausreichend starke Schwingung erzeugt werden. Bei zunehmenden Prozessdruck, der zu einer Entlastung des Piezostapels bei einem Vibrations-Grenzstandschalter 10 gemäß Figur 1 führen kann, wird dadurch eine reduzierte Funktionsfähigkeit des piezoelektrischen Antriebs 20 verursacht, sodass bevorzugt der elektromagnetische Antrieb 30 zur Schwingungserzeugung und -detektion eingesetzt wird. Auf Grund der bei erhöhtem Druck geringeren Viskosität der thixotropen Medien ist in diesem Anwendungsbeispiel der elektromagnetische Antrieb 30 dann auch geeignet, eine ausreichend große Schwingung der Membran 1 zur Grenzstandsdetektion zu erzeugen.

Eine Auswahl des für die Schwingungserzeugung zu verwendenden Antriebs kann dabei insbesondere auf Basis von zusätzlich ermittelten Prozessparametern wie beispielsweise der Prozesstemperatur, der Viskosität des zu messenden Prozessmediums und des Prozessdrucks erfolgen.

### Bezugszeichenliste

- 1: Membran
- 3: Zubolzen
- 4: Magnetaufnahme / Spannmutter
- 5: Permanentmagnet
- 6: Spule
- 7: Spulenkern
- 8: Spulenaufnahme

- 10: Vibrations-Grenzstandsschalter
- 11: Schwingeinheit / Schwinggabel

- 15: Gehäuse
- 20: piezoelektrischer Antrieb
- 21: Druckring

- 30: elektromagnetischer Antrieb

- 100: Antriebseinheit

- 2a: Anpassungskeramik
- 2b: Piezoelement

## Patentansprüche

1. Vibrations-Grenzstandschalter (10) mit einer in Schwingung versetzbaren Membran (1) und einer Antriebseinheit (100), zum Versetzen der Membran (1) in Schwingung und/oder zum Abgreifen einer Schwingung der Membran (1),
**dadurch gekennzeichnet, dass**
die Antriebseinheit (100) wenigstens einen elektromagnetischen Antrieb (30) und einen piezoelektrischen Antrieb (20) umfasst.

2. Vibrations-Grenzstandschalter gemäß Anspruch 1,
**dadurch gekennzeichnet, dass**
an der Membran eine Schwingeinheit (11) angeordnet ist.

3. Vibrations-Grenzstandschalter (10) gemäß Anspruch 1 oder 2,
**dadurch gekennzeichnet, dass**
der elektromagnetische Antrieb (30) und der piezoelektrische Antrieb (20) derart angeordnet sind, dass wahlweise der elektromagnetische Antrieb (30) und/oder der piezoelektrische Antrieb (20) zum in Schwingung versetzen der Membran (1) nutzbar ist.

4. Vibrations-Grenzstandschalter (10) gemäß einem der vorhergehenden Ansprüche,
**dadurch gekennzeichnet, dass**
der elektromagnetische (30) und der piezoelektrische Antrieb (20) mechanisch in Reihe geschaltet sind.

5. Vibrations-Grenzstandschalter (10) gemäß einem der vorhergehenden Ansprüche,
**dadurch gekennzeichnet, dass**
der piezoelektrische Antrieb (20) zwischen der Membran (1) und dem elektromagnetischen Antrieb (30) angeordnet ist.

6. Vibrations-Grenzstandschalter (10) gemäß Anspruch 5,
**dadurch gekennzeichnet, dass**
an der Membran (1) ein Zugbolzen (3) angeordnet ist.

7. Vibrations-Grenzstandschalter (10) gemäß Anspruch 6,
**dadurch gekennzeichnet, dass**
der elektromagnetische Antrieb (30) rückseitig auf den Zugbolzen (3) wirkt.

8. Vibrations-Grenzstandschalter (10) gemäß Anspruch 7,
**dadurch gekennzeichnet, dass**
der elektromagnetische Antrieb (30) mit dem Zugbolzen (3) fest verbunden, bevorzugt verschraubt ist

9. Vibrations-Grenzstandschalter (10) gemäß Anspruch 8,
**dadurch gekennzeichnet, dass**
der elektromagnetische Antrieb (30) derart mit dem Zugbolzen (3) verschraubt ist, dass er den piezoelektrischen Antrieb (20) gegen die Membran (1) spannt.

10. Vibrations-Grenzstandschalter (10) gemäß einem der Ansprüche 6 - 9,
**dadurch gekennzeichnet, dass**
der Zugbolzen (3) wenigstens abschnittsweise als Spulenkern des elektromagnetischen Antriebs (30) ausgebildet und angeordnet ist.

11. Vibrations-Grenzstandschalter (10) gemäß einem der Ansprüche 6 - 10,
**dadurch gekennzeichnet, dass**
der Zugbolzen (3) mit einer Spulenaufnahme(8) oder einer Magnetaufnahme (4) des elektromagnetischen Antriebs (30) fest verbunden ist.

12. Vibrations-Grenzstandschalter (10) gemäß Anspruch 11,
**dadurch gekennzeichnet, dass**
die Spulen- oder Magnetaufnahme (8) als Spannschraube ausgebildet ist.

13. Vibrations-Grenzstandschalter (10) gemäß einem der vorhergehenden Ansprüche,
**dadurch gekennzeichnet, dass**
der piezoelektrische Antrieb (20) eine Mehrzahl gestapelt angeordneter, ringförmig ausgebildeter Piezoelemente (2b) aufweist.

14. Vibrations-Grenzstandschalter (10) gemäß einem der Ansprüche 1 bis 8,
**dadurch gekennzeichnet, dass**
der piezoelektrische Antrieb (20) ein ringförmiges Piezoelement (2b) aufweist, das unmittelbar oder unter Zwischenschaltung einer Anpassungskeramik (2a) mit der Membran verklebt ist.

15. Verfahren zum Betreiben eines Vibrations-Grenzstandschalters (10) gemäß einem der vorhergehenden Ansprüche, mit folgenden Schritten:
- Versetzen der Membran (1) in Schwingung
- Detektieren einer resultierenden Schwingung, wobei wahlweise ein elektromagnetischer Antrieb (30) und/oder ein piezoelektrischer Antrieb (20) zum Versetzen der Membran (1) in Schwingung und/oder Detektieren der resultierenden Schwingung verwendet wird.

16. Verfahren gemäß Anspruch 15,
**dadurch gekennzeichnet, dass**
eine Auswahl des zu verwendenden Antriebs (100) abhängig von einer Viskosität und/oder Temperatur eines Prozessmediums erfolgt.

17. Verfahren gemäß einem der Ansprüche 15 oder 16,
**dadurch gekennzeichnet, dass**
der eine Antrieb (100) zum Versetzen der Membran (1) in Schwingung und der andere Antrieb (100) zum Detektieren der resultierenden Schwingung verwendet wird.

## Claims

1. Vibration level switch (10) having a membrane (1) which can be set in oscillation and a drive unit (100) for setting the membrane (1) in oscillation and/or for detecting an oscillation of the membrane (1), **characterized in that** the drive unit (100) comprises at least one electromagnetic drive (30) and one piezoelectric drive (20).

2. Vibration level switch according to claim 1, **characterized in that** an oscillating unit (11) is arranged on the membrane.

3. Vibration level switch (10) according to claim 1 or 2, **characterized in that** the electromagnetic drive (30) and the piezoelectric drive (20) are arranged in such a way that optionally the electromagnetic drive (30) and/or the piezoelectric drive (20) can be used to set the membrane (1) in oscillation.

4. Vibration level switch (10) according to any of the preceding claims, **characterized in that** the electromagnetic (30) and the piezoelectric drive (20) are mechanically connected in series.

5. Vibration level switch (10) according to any of the preceding claims, **characterized in that** the piezoelectric drive (20) is arranged between the membrane (1) and the electromagnetic drive (30).

6. Vibration level switch (10) according to claim 5, **characterized in that** a tension bolt (3) is arranged on the membrane (1).

7. Vibration level switch (10) according to claim 6, **characterized in that** the electromagnetic drive (30) acts on the rear of the tension bolt (3).

8. Vibration level switch (10) according to claim 7, **characterized in that** the electromagnetic drive (30) is securely connected, preferably screwed, to the tension bolt (3).

9. Vibration level switch (10) according to claim 8, **characterized in that** the electromagnetic drive (30) is screwed to the tension bolt (3) in such a way that it clamps the piezoelectric drive (20) against the membrane (1).

10. Vibration level switch (10) according to any of claims 6 to 9, **characterized in that** the tension bolt (3), at least in some sections, is configured and arranged as a coil core of the electromagnetic drive (30).

11. Vibration level switch (10) according to any of claims 6 to 10, **characterized in that** the tension bolt (3) is securely connected to a coil holder (8) or a magnet holder (4) of the electromagnetic drive (30).

12. Vibration level switch (10) according to claim 11, **characterized in that** the coil holder or magnet holder (8) is configured as a clamping screw.

13. Vibration level switch (10) according to any of the preceding claims, **characterized in that** the piezoelectric drive (20) has a plurality of ring-shaped piezo elements (2b) arranged in a stacked manner.

14. Vibration level switch (10) according to any of claims 1 to 8, **characterized in that** the piezoelectric drive (20) has a ring-shaped piezo element (2b) which is adhesively bonded to the membrane directly or with the interposition of an adjustment ceramic (2a).

15. Method for operating a vibration level switch (10) according to any of the preceding claims, comprising the following steps:
- setting the membrane (1) in oscillation
- detecting a resulting oscillation, wherein optionally an electromagnetic drive (30) and/or a piezoelectric drive (20) is used to set the membrane (1) in oscillation and/or to detect the resulting oscillation.

16. Method according to claim 15, **characterized in that** the drive (100) to be used is selected as a function of a viscosity and/or temperature of a process medium.

17. Method according to either of claims 15 or 16, **characterized in that** one drive (100) is used to set the membrane (1) in oscillation and the other drive (100) is used to detect the resulting oscillation.

## Revendications

1. Commutateur de niveau à vibration (10) comprenant une membrane (1) pouvant être mise en oscillation et une unité d'entraînement (100) pour mettre la membrane (1) en oscillation et/ou prélever une oscillation de la membrane (1),
**caractérisé en ce que**
l'unité d'entraînement (100) comprend au moins un élément d'entraînement électromagnétique (30) et un élément d'entraînement piézoélectrique (20).

2. Commutateur de niveau à vibration conforme à la revendication 1,
**caractérisé en ce qu'**
une unité d'oscillation (11) est montée sur la membrane.

3. Commutateur de niveau à vibration (10) conforme à la revendication 1 ou 2,
**caractérisé en ce que**
l'élément d'entraînement électromagnétique (30) et l'élément d'entraînement piézoélectrique (20) sont montés de façon à pouvoir utiliser sélectivement l'élément d'entraînement électromagnétique (30) et/ou l'élément d'entraînement piézoélectrique (20) pour mettre la membrane (1) en oscillation.

4. Commutateur de niveau à vibration (10) conforme à l'une des revendications précédentes,
**caractérisé en ce que**
l'élément d'entraînement électromagnétique (30) et l'élément d'entraînement piézoélectrique (20) sont branchés mécaniquement en série.

5. Commutateur de niveau à vibration (10) conforme à l'une des revendications précédentes,
**caractérisé en ce que**
l'élément d'entraînement piézoélectrique (20) est monté entre la membrane (1) et l'élément d'entraînement électromagnétique (30).

6. Commutateur de niveau à vibration (10) conforme à la revendication 5,
**caractérisé en ce qu'**
un tirant (3) est monté sur la membrane (1).

7. Commutateur de niveau à vibration (10) conforme à la revendication 6,
**caractérisé en ce que**
l'élément d'entraînement électromagnétique (30) agit par l'arrière sur le tirant (3).

8. Commutateur de niveau à vibration (10) conforme à la revendication 7,
**caractérisé en ce que**
l'élément d'entraînement électromagnétique (30) est relié solidairement au tirant (3), et est de préférence vissé sur celui-ci.

9. Commutateur de niveau à vibration (10) conforme à la revendication 8,
**caractérisé en ce que**
l'élément d'entraînement électromagnétique (30) est vissé sur le tirant (3) de sorte qu'il serre l'élément d'entraînement piézoélectrique (20) contre la membrane (1).

10. Commutateur de niveau à vibration (10) conforme à l'une des revendications 6 à 9,
**caractérisé en ce que**
le tirant (3) est réalisé et monté au moins par segments sous la forme d'un noyau de bobine de l'élément d'entraînement électromagnétique (30).

11. Commutateur de niveau à vibration (10) conforme à l'une des revendications 6 à 9,
**caractérisé en ce que**
le tirant (3) est relié solidairement à un logement de réception de bobine (8) ou à un logement de réception d'aimant (4) de l'élément d'entraînement électromagnétique (30).

12. Commutateur de niveau à vibration (10) conforme à la revendication 11,
**caractérisé en ce que**
le logement de réception de bobine ou le logement de réception d'aimant (8) est réalisé sous la forme d'une vis de serrage.

13. Commutateur de niveau à vibration (10) conforme à l'une des revendications précédentes,
**caractérisé en ce que**
l'élément d'entraînement piézoélectrique (20) comporte un ensemble d'éléments piézoélectriques (2b) annulaires empilés les uns sur les autres.

14. Commutateur de niveau à vibration (10) conforme à l'une des revendications 1 à 8,
**caractérisé en ce que**
l'élément d'entraînement piézoélectrique (20) comporte un élément piézoélectrique annulaire (2b) qui est collé sur la membrane directement ou avec interposition d'une céramique d'adaptation (2a).

15. Procédé d'actionnement d'un commutateur de niveau à vibration (10) conforme à l'une des revendications précédentes,
**caractérisé en ce qu'**
il comprend les étapes consistant à :
- mettre la membrane (1) en oscillation,
- détecter l'oscillation résultante, un élément d'entraînement électromagnétique (30) et/ou un élément d'entraînement piézoélectrique (20) étant sélectivement utilisés pour mettre la membrane (1) en oscillation et/ou détecter l'oscillation résultante.

16. Procédé conforme à la revendication 15,
**caractérisé en ce que**
la sélection de l'élément d'entraînement (100) à utiliser est effectuée en fonction de la viscosité et/ou de la température d'un fluide de process.

17. Procédé conforme à l'une des revendications 15 et 16,
**caractérisé en ce que**
l'un des éléments d'entraînement (100) est utilisé pour mettre la membrane (1) en vibration alors que l'autre l'élément d'entraînement (100) est utilisé pour détecter l'oscillation résultante.
